(19) Europäisches Patentamt

European Patent Office

Office européen des brevets

(11) **EP 0 473 970 B1**

(12) **EUROPÄISCHE PATENTSCHRIFT**

(45) Veröffentlichungstag und Bekanntmachung des Hinweises auf die Patenterteilung:
**13.11.1996 Patentblatt 1996/46**

(51) Int Cl.⁶: **G08B 13/24**

(21) Anmeldenummer: **91113457.5**

(22) Anmeldetag: **10.08.1991**

(54) **Verfahren zur Herstellung von elektrischen Schwingkreisen, insbesondere Resonanz-Etiketten**

Method for producing electric resonant circuits, particulary resonance-tag

Procédé pour la production de circuits éléctriques résonnantes, en particulier d'étiquettes à résonance

(84) Benannte Vertragsstaaten:
**BE DE DK ES FR GB IT NL SE**

(30) Priorität: **17.08.1990 CH 2684/90**

(43) Veröffentlichungstag der Anmeldung:
**11.03.1992 Patentblatt 1992/11**

(73) Patentinhaber: **KOBE PROPERTIES LIMITED**
**Douglas, Isle of Man, British Isles (GB)**

(72) Erfinder: **Pichl, Fritz**
**CH-8802 Kilchberg (CH)**

(74) Vertreter: **Troesch Scheidegger Werner AG**
**Patentanwälte,**
**Siewerdtstrasse 95,**
**Postfach**
**8050 Zürich (CH)**

(56) Entgegenhaltungen:
**EP-A- 0 380 426      BE-A- 0 902 846**

## Beschreibung

Die Erfindung betrifft ein Verfahren zur Herstellung von elektrischen Schwingkreisen, insbesondere von Resonanz-Etiketten zur Verwendung in einem Diebstahl-Sicherungssystem, bei welchen eine Spule und ein Kondensator auf ein Dielektrikum aufgebracht jeweils einen Schwingkreis bilden, wobei die Spule in Form einer Spirale und eine Fläche des Kondensators auf der einen Seite und die zweite Fläche des Kondensators auf der anderen Seite des Dielektrikums angeordnet sind.

Elektrische Schwingkreise dieser Art auf einer Trägerfolie aufgebracht und anschliessend weiter konfektioniert, um als Klebeetiketten oder in Kunststoff-Hartschalen eingebracht in einem Diebstahl-Sicherungssystem verwendet zu werden, wurden bisher (s. z.B. EP-A-0380426) meistens mittels eines Ätzverfahrens hergestellt, bei dem das Basismaterial aus zwei durch eine nichtleitende Schicht wie beispielsweise Plastikmaterial getrennten Aluminiumfolien besteht und durch Aufdrukken eines ätzmediumresistenten Lackes auf die beiden Aluminiumfolien die gewünschte Form des aus einer Spule und einem Kondensator bestehenden Schwingkreises festgelegt wird. Wenn durch den Ätzvorgang die unerwünschten Teile der Aluminiumfolie entfernt sind, verbleiben eine Spule in Form einer flächigen Spirale sowie eine erste Kondensatorfläche auf der einen Seite der Trägerfolie und auf der anderen Seite der Trägerfolie entsteht durch den Ätzvorgang eine zweite Kondensatorfläche, die mit der ersten noch elektrisch zu verbinden ist.

Für die Herstellung dieser bekannten Resonanz-Etiketten wird aus Kostengründen meistens Aluminiumfolie verwendet und bei dieser Herstellung muss ein nach dem Ätzprozess übrig bleibender giftiger Ätzschlamm entsorgt werden, was unter Berücksichtigung des Umweltschutzes erfolgen muss, dem heute ganz besondere Beachtung geschenkt wird. Eine umweltgerechte Entsorgung führt zu nicht unwesentlich höheren Kosten.

Der vorliegenden Erfindung lag daher die Aufgabe zugrunde, den Anfall von giftigem Ätzschlamm wesentlich zu reduzieren, womit die Bemühungen um einen verstärkten Umweltschutz unterstützt und Kosten für die Entsorgung eingespart werden.

Zur Lösung dieser Aufgabe wird ein Verfahren gemäss Anspruch 1 vorgeschlagen, bei dem nur noch die eine Seite einem Ätzvorgang unterworfen wird, während auf die andere Seite die erforderliche zweite Kondensatorfläche aufgesiegelt wird, sodass entsprechend weniger giftiger Ätzschlamm anfällt.

Das Verfahren wird nachfolgend anhand einer Zeichnung erläutert, die eine Vielzahl von nach dem Verfahren hergestellten Schwingkreisen insbesondere für Resonanz-Etiketten zeigt, die zusammenhängend hergestellt werden.

Im Unterschied zu dem bekannten Herstellungsverfahren wird bei diesem Verfahren nicht von einer Sandwich-Konstruktion bestehend aus einer Aluminiumfolie, einer Trägerfolie und einer Aluminiumfolie ausgegangen, sondern es kommt als Grundmaterial eine koextrutierte Aluminiumfolie auf einer Kunststoff-Trägerfolie zum Einsatz, vorzugsweise wird einer 50 μ-Aluminiumfolie auf einer 20-30 μ-Polyäthylenfolie verwendet. Diese Trägerfolie kann dann auch die Funktion des Dielektrikums übernehmen. Die Aluminiumfolie wird in bekannter Weise mit ätzmedienresistentem Lack bedruckt und nach dem Trocknungsprozess des Lackes wird der unbedruckte Teil der Aluminiumfolie weggeätzt. Auf der Trägerfolie 1 erhält man dann eine Spule 2 in Form einer Spirale sowie eine benachbart zur innersten Windung der Spirale sich befindende erste Kondensatorfläche 3. Gleichzeitig entsteht durch den Ätzvorgang am aussenliegenden Ende der Spirale 2 noch eine kleine Zusatzfläche 4, die zur elektrischen Verbindung mit der auf der anderen Seite aufzubringenden zweiten Kondensatorfläche dient.

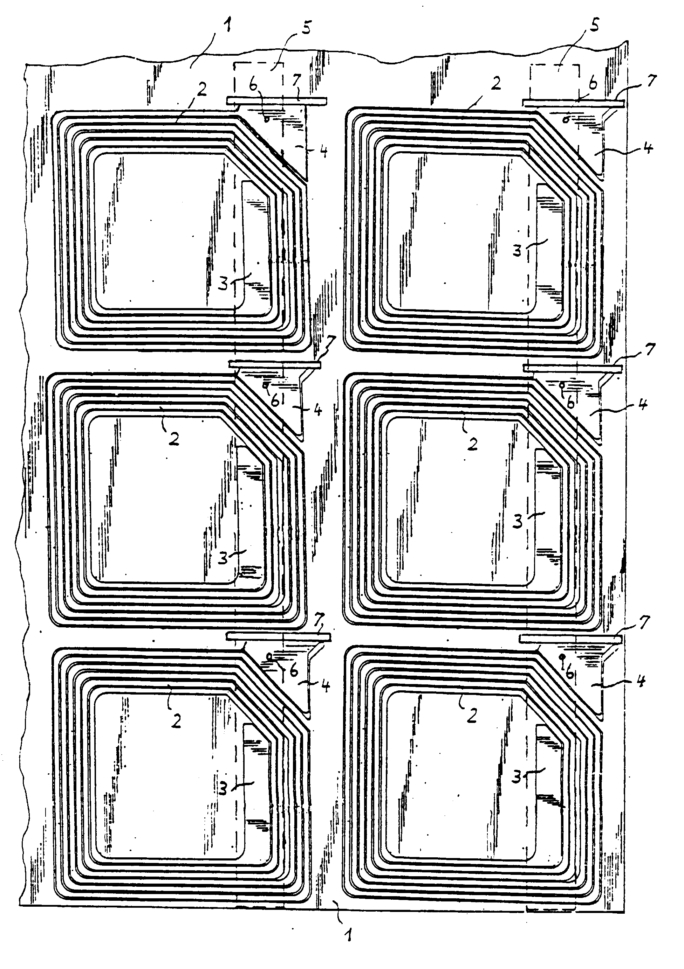

Bei der aus der Zeichnung erkennbaren Anordnung und Ausgestaltung von Spirale 2 und erster Kondensatorfläche 3 sind die folgenden Gesichtspunkte ausschlaggebend:

Bei der Auslegung eines Schwingkreises besteht das Problem darin, Kosten und Leistung in Einklang zu bringen. Die Kosten für das Ätzverfahren werden pro Flächeneinheit gerechnet, weshalb die Resonanz-Etikette möglichst klein hergestellt werden sollte, während andererseits inbezug auf die Leistung eine grössere Spule bei Anwendung in dem Sicherungssystem gegen Diebstahl ein stärkeres Signal entstehen lässt, das von der Grösse des Durchmessers der Spule abhängig ist. Um daher ein möglichst grosses freies Feld innerhalb der Spule zu erhalten, ist man bemüht, den Kondensator möglichst klein zu gestalten. Bislang hat man daher auf dem begrenzten Raum einer Resonanz-Etikette auf beiden Seiten der Trägerfolie zwei sich deckende Flächen angeordnet oder auch zwei gegenläufige Leiterbahnabschnitte zu beiden Seiten der Trägerfolie in Deckungslage hergestellt, um den Kondensator zu bilden, wobei jedoch beim Druckvorgang eine dieser beiden Flächen oder Leiterbahnabschnitte breiter als die andere ausgeführt werden musste, um sicherzustellen, dass die beiden Flächen oder Leiterbahnabschnitte des Kondensators auch wirklich flächendeckend einander gegenüberliegen. Bei Anwendung dieser Technik verliert man jedoch einen Teil der freien Fläche für den Durchtritt von Magnetfeldlinien, was wiederum ein schwächeres Signal zur Folge hat.

Um auch diese vorstehend geschilderten Schwierigkeiten zu vermeiden, wird bei dem erfindungsgemässen Verfahren nur auf einer Seite der Trägerfolie ein Ätzvorgang durchgeführt, sodass neben dem Vorteil der Reduktion der anfallenden Ätzschlammmenge auch der weitere Vorteil erzielt wird, dass die durch einen gegenflächigen Druckvorgang sich ergebende Flächenverschwendung vermieden werden kann. Durch den Ätzvorgang entsteht daher bei der erfindungsgemäss hergestellten Resonanz-Etikette eine kleine benachbart zur innersten Windung der Spirale liegende erste Kondensatorfläche 3, durch die die freie Fläche innerhalb der Spirale 2 nur wenig reduziert wird.

Wie aus der Zeichnung hervorgeht, werden auf einer grösseren Bahn der Trägerfolie 1 eine Vielzahl von Spiralen 2 mit jeweils einer Kondensatorfläche 3 und einer Zusatzfläche 4 hintereinander und nebeneinander mit Hilfe des Ätzverfahrens hergestellt. Erfindungsgemäss wird dann als nächster Schritt auf die andere Seite der Trägerfolie 1 ein gestrichelt dargestellter Aluminiumfolienstreifen 5 derart aufgesiegelt, dass er sich in Deckungslage bezüglich der ersten Kondensatorfläche 3 und einiger Leiterbahnen der Spirale 2 befindet und auch in Deckungslage zur Zusatzfläche 4 mindestens teilweise ist. Dieser Aluminiumfolienstreifen 5 stellt die zweite Kondensatorfläche dar. zu dem eine elektrische Verbindung von der Zusatzfläche 4 beispielsweise durch Crimpen bei 6 hergestellt wird. Durch Stanzschnitte 7 muss der durchgehende Streifen 5 dann nur noch getrennt werden, bevor die Trägerfolie 1 durch Quer- und Längsschnitte zertrennt wird, um die einzelnen Schwingkreise für eine anschliessende Konfektionierung beispielsweise zur Verwendung als Resonanz-Etiketten zu erhalten.

Die Zeichnung zeigt nur einen Ausschnitt aus einer grossen Bahn, die am Ende eine Rolle bilden kann. Eine Rolle kann nebeneinander mehrere Bahnen hintereinander angeordneter Spiralen enthalten oder auch nur aus einer Bahn bestehen oder es kann eine breitere Rolle in verschiedene Bahnen aufgeteilt werden.

Beim Aufsiegeln des Aluminiumfolienstreifens 5 auf die Trägerfolie 1 kann erforderlichenfalls auch noch eine Oberflächenbehandlung dieser Trägerfolie durchgeführt werden wie beispielsweise eine Coronabehandlung. Als Trägerfolie, die gleichzeitig auch das Dielektrikum bildet, können Folien wie z.B. aus Poylpropylen, Polystyrol oder Polyäthylen sowie auch LDPE und HDPE verwendet werden. Folien aus diesen Materialien haben gute dielektrische Werte im gewünschten Frequenzbereich und sind siegelfähig.

Das Aufsiegeln des Streifens 5 erfolgt mit Hilfe von beheizten Rollen oder Stempeln, wobei Druck und/oder Temperatur gesteuert werden und wobei auch eine ständige Kontrolle der Materialdicke der Folie durchgeführt wird, weil die Kapazität eines Kondensators von der Dicke des zwischen den Kondensatorflächen vorhandenen Dielektrikums abhängig ist, wobei die Kapazität mit zunehmender Dicke abnimmt.

Die Kapazität des Kondensators beeinflusst wiederum die Frequenz, bei der eine Resonanz-Etikette resonant wird. Für die Frequenz gilt die Beziehung:

$$f = \frac{1}{2\pi\sqrt{L \cdot C}} \, ,$$

worin L die Induktivität und C die Kapazität ist. Die Induktivität hängt von der Auslegung der Spule ab und ist nach dem Ätzvorgang eine konstante Grösse, sodass nur noch die Kapazität durch Veränderung der Materialdicke der Trägerfolie beim Aufsiegeln des Aluminiumfolienstreifens 5 beeinflussbar ist. Daher wird in bevorzugter Weise während des Siegelvorgangs die Frequenzgenauigkeit kontrolliert. Hierzu dient beispielsweise ein heute vielfach angewendeter PC-gesteuerter Messvorgang, der Ist- und Sollwerte vergleicht.

Die fertig hergestellten Schwingkreise können in verschiedener Weise konfektioniert werden und bilden mit Papier und Klebstoff beschichtet sogenannte Resonanz-Etiketten die beispielsweise den Warenpreis oder andere Angaben tragen. Die Schwingkreise können auch in Hartplastikschalen eingebracht werden, die an der Ware befestigt werden und in einem Diebstahl-Sicherungssystem dem gleichen Zweck dienen, beim Passieren eines Magnetfeldes am Warenhausausgang einen Alarm auszulösen, wenn der Kondensator nicht vorher an der Kasse beim Bezahlen der Ware abgeschaltet worden ist, was durch Herstellung einer leitenden Verbindung der beiden Kondensatorflächen erfolgt.

**Patentansprüche**

1. Verfahren zur Herstellung von elektrischen Schwingkreisen, insbesondere Resonanz-Etiketten zur Verwendung in einem Diebstahl-Sicherungssystem, bei welchen eine Spule und ein Kondensator auf ein Dielektrikum aufgebracht jeweils einen Schwingkreis bilden, wobei die Spule in Form einer Spirale und eine Fläche des Kondensators auf der einen Seite und die zweite Fläche des Kondensators auf der anderen Seite des Dielektrikums angeordnet sind, dadurch gekennzeichnet, dass anschliessend an die Herstellung einer Spirale (2) und der ersten Kondensatorfläche (3) aus auf eine, ggf. das Dielektrikum bildenden Trägerfolie (1) aufgebrachten Aluminiumfolie mittels Ätzverfahren auf die andere Seite der Trägerfolie (1) ein Aluminiumfolienstreifen (5) mit ggf. zur Trägerfolie hin aufgebrachtem Dielektrikum in Deckungslage bezüglich der ersten Kondensatorfläche (3) aufgesiegelt wird, um die zweite Kondensatorfläche zu bilden und dass eine elektrische Verbindung zwischen den Leitern auf den beiden Seiten des Dielektrikums erstellt wird.

2. Verfahren nach Anspruch 1, dadurch gekennzeichnet, dass auf der die Spirale (2) aufweisenden Seite der Trägerfolie (1) in der Aluminiumfolie durch Ätzverfahren eine an die äusserste Windung der Spirale (2) angrenzend angeordnete und mit der Spirale elektrisch verbundene Zusatzfläche (4) erzeugt wird, die sich zumindest teilweise in Deckungslage bezüglich des auf der anderen Seite der Trägerfolie (1) aufgesiegelten Aluminiumfolienstreifens (5) befindet und zur elektrischen Verbindung mit diesem Streifen dient.

3. Verfahren nach Anspruch 1, dadurch gekennzeichnet, dass auf der einen Seite einer Trägerfolie (1) eine Vielzahl von einzelnen Spiralen (2) und ersten Kondensatorflächen (3) hinter- und/oder nebeneinander durch Ätzverfahren hergestellt wird und dass anschliessend auf die andere Seite der Trägerfolie (1) ein in Deckungslage mit allen hintereinanderliegend angeordneten Kondensatorflächen (3) und einigen Leiterbahnen der jeweiligen Spirale (2) sich durchgehend erstreckender Aluminiumfolienstreifen (5) aufgesiegelt wird.

4. Verfahren nach einem der Ansprüche 1-3, dadurch gekennzeichnet, dass der Aluminiumfolienstreifen (5) unter gesteuerter Druck- und/oder Temperaturanwendung auf die Trägerfolie (1) aufgesiegelt wird und gleichzeitig deren Materialstärke durch Messung kontrolliert und eventuell verändert wird.

5. Verfahren nach Anspruch 3, dadurch gekennzeichnet, dass der durchgehende Aluminiumfolienstreifen (5) in gleichmässigen Abständen entsprechend den Abständen der Spiralen (2) durchgetrennt und jeder getrennte Abschnitt mit der auf der anderen Seite der Trägerfolie (1) befindlichen Zusatzfläche (4) am Aussenende der Spirale (2) elektrisch leitend verbunden wird.

6. Verfahren nach einem der vorhergehenden Ansprüche 1-5, dadurch gekennzeichnet, dass als Trägerfolie (1) Polypropylen oder Polyäthylen oder Polystyrol verwendet wird.

7. Elektrischer Schwingkreis, insbesondere Resonanz-Etikette hergestellt nach dem Verfahren gemäss einem oder mehreren der Ansprüche 1-6, gekennzeichnet durch eine auf der einen Seite einer Trägerfolie (1) aus einer auf diese aufgebrachten Aluminiumfolie durch Ätzverfahren hergestellten Spirale (2) und eine erste Kondensatorfläche (3) und einen auf der anderen Seite der Trägerfolie (1) in Deckungslage bezüglich der ersten Kondensatorfläche (3) und einiger Leiterbahnen der Spirale aufgesiegelten Aluminiumfolienstreifen (5) als zweite Kondensatorfläche.

**Claims**

1. Method of producing electric resonant circuits, specifically resonant labels for use in a theft protection system, in which a coil and a capacitor located on a surface of a dielectric substrate form a respective resonant circuit, whereby said coil has the shape of a spiral and a first surface of the capacitor is arranged on one side and the second surface of the capacitor is arranged on the other side of said dielectric substrate, characterized in that following the production of a spiral (2) and of said first surface (3) of the capacitor from an aluminium foil applied on a supporting foil (1) forming optionally said dielectric substrate, by means of an etching process, an aluminium foil strip (5) having optionally a dielectric substrate placed thereupon facing said supporting foil is sealed onto the other side of said supporting foil in a position superimposing said first capacitor surface (3), to thereby form said second capacitor surface, and by establishing an electrical connection between the conductors on both sides of the dielectric substrate.

2. The method of claim 1, characterized in that on the side of the supporting foil (1) having the spiral (2) a supplementary surface (4) bordering the outermost winding of the spiral (2) and connected electrically to the spiral is produced in the aluminium foil by an etching process, which supplementary surface is located at least partly in a superimposed position relative to the aluminium foil strip (5) sealed onto the other side of the supporting foil (1) and serves as electrical connection to this strip.

3. The method of claim 1, characterized in that a plurality of single spirals (2) and first capacitor surfaces (3) which are arranged consecutively behind each other and/or side by side are produced at the one side of a supporting foil (1) by an etching process, and wherein thereafter a continuously extending aluminium foil strip (5) is sealed onto the other side of the supporting foil (1) at a position superimposed relative to all capacitor surfaces arranged consecutively behind each other and to some conductor tracks of the respective spiral (2).

4. The method of claim 1, characterized in that the aluminium foil strip (5) is sealed by an application of controlled pressure and/or temperature onto the supporting foil (1) and at the same time their thickness is checked by a measuring and if needed is changed.

5. The method of claim 3, characterized in that the continuous aluminium foil strip (5) is severed at equal distances corresponding to the distances of the spirals (2) and every severed portion is electrically conductively connected at the outer end of the spiral (2) to the supplementary surface (4) located at the other side of the supporting foil (1).

6. The method of any of claims 1-5, characterized in that polypropylene or polyethylene or polystyrene is used as supporting foil.

7. An electrical resonant circuit, specifically a resonant-tag produced in accordance with the method of one or several of claims 1-6, characterized in that it comprises a supporting foil (1), a spiral (2) located thereupon produced from an aluminium foil placed thereupon by an etching process and a first capacitor surface (3), and an aluminium foil strip (5) as second capacitor surface sealed onto the other side of the supporting foil (1) at a location superimposed relative to the first capacitor surface (3) and a number of conductor tracks of the spiral.

**Revendications**

1. Procédé pour la fabrication de circuits électriques résonnants, en particulier d'étiquettes à résonance, destinées à être utilisées dans un système de protection anti-vol, dans lequel une bobine et un condensateur placés sur une surface d'un diélectrique forment un circuit résonnant correspondant, ladite bobine ayant la forme d'une spirale et une première surface du condensateur étant prévue sur une face et la seconde surface du condensateur étant prévue sur l'autre face du diélectrique, caractérisé en ce qu'en suite de la production par un procédé d'enlevage chimique d'une spirale (2) et de ladite première surface (3) du condensateur à partir d'une feuille aluminium appliquée sur une feuille support (1) formant le cas échéant ledit diélectrique, une bande d'aluminium (5) sur laquelle est placé le cas échéant un diélectrique en face de la feuille support est scellée sur l'autre face de la feuille support dans une position superposant ladite première surface (3) du condensateur pour ainsi former ladite seconde surface du condensateur, et en ce qu'une connexion électrique est réalisée entre les conducteurs sur les deux faces du diélectrique.

2. Procédé selon la revendication 1, caractérisé en ce que sur la face de la feuille support (1) présentant la spirale (2) une surface supplémentaire (4) est produite par un procédé d'enlevage chimique, confinant la spire extérieure de la spirale (2) et reliée électriquement à la spirale, cette surface supplémentaire étant placée au moins partiellement dans une position de superposition par rapport à la bande en feuille d'aluminium (5) scellée sur l'autre face de la feuille support (1) et servant de connexion électrique avec cette bande.

3. Procédé selon la revendication 1, caractérisé en ce qu'un nombre de spirales (2) et de premières surfaces de condensateur (3) individuels qui sont arrangés les uns derrière les autres et/ou côte à côte sont produits par un procédé d'enlevage chimique sur une face de la feuille support (1), et en ce qu'ensuite une bande (5) en feuille d'aluminium continue est scellée sur l'autre face de la feuille support (1) dans une position de superposition par rapport à toutes les surfaces de condensateur placées consécutivement l'une derrière l'autre et par rapport à quelques conducteurs des spirales correspondantes (2).

4. Procédé selon la revendication 1, caractérisé en ce que la bande (5) en feuille d'aluminium est scellée par application d'une pression et/ou température contrôlées sur ladite feuille support (1) tout en contrôlant en même temps leur épaisseur par mesurage et en changeant éventuellement cette épaisseur.

5. Procédé selon la revendication 3, caractérisé en ce que la bande (5) continue en feuille d'aluminium est séparée à des intervalles correspondant à la distance des spirales (2), chaque portion séparée étant électriquement connectée par l'extrémité extérieure de la spirale (2) avec la surface supplémentaire (4) placée sur l'autre face de la feuille support (1).

6. Procédé selon l'une quelconque des revendications 1-5, caractérisé en ce que du polypropylène ou polyéthylène ou polystirène est utilisé pour former la feuille support (1).

7. Circuit électrique résonnant, en particulier étiquette de résonance, produit selon le procédé selon une ou plusieurs des revendications 1-6, caractérisé par une feuille support (1), une spirale (2) placée sur cette dernière et produite par un procédé d'enlevage chimique à partir d'une feuille d'aluminium placée sur le support et une première surface de condensateur (3), ainsi que par une bande (5) en feuille d'aluminium comme seconde surface de condensateur scellée sur l'autre face de la feuille support (1) à un emplacement de superposition par rapport à la première surface de condensateur (3) et un nombre de conducteurs de la spirale.